# EUROPEAN PATENT APPLICATION

(11) **EP 4 617 740 A1**
(43) Date of publication of application: **17.09.2025**
(21) Application number: 24162806.4
(22) Date of filing: 11.03.2024
(51) Int. Cl.: G02B 6/12

(54) **MONITOR PHOTODIODE, PHOTONIC INTEGRATED CIRCUIT, OPTO-ELECTRONIC SYSTEM, AND METHOD**

(71) Applicant: EFFECT Photonics B.V., 5656 AE Eindhoven (NL)
(72) Inventor: Kleijn, Emil, 5656AE Eindhoven (NL); Lunghi, Tommaso, 5656AE Eindhoven (NL); Koene, Tim, 5656AE Eindhoven (NL)
(74) Representative: Kramer-Ograjensek, Petra

(57) **Abstract**

The invention relates to a monitor photodiode (1) for absorbing at most 5% of optical radiation to which the monitor photodiode is exposed if the monitor photodiode is in use. The monitor photodiode comprises a layer stack (5) having a semiconductor-based core layer (6), a semiconductor-based absorption layer (9), and a semiconductor-based cladding layer (12) that is provided with an elevated elongated portion (15). The semiconductor-based absorption layer and the elevated elongated portion are arranged relative to each other in such a way that an overlap between a mode field of the optical radiation that is present in the semiconductor-based core layer if the monitor photodiode is in use and the semiconductor-based absorption layer results in an optical absorption of at most 5%.

The invention also relates to a PIC (100) comprising a monitor photodiode according to the invention, an opto-electronic system (200) comprising such a PIC, and a method for fabricating the monitor photodiode.

## Description

### FIELD OF THE INVENTION

The present invention relates to a monitor photodiode for absorbing at most 5% of optical radiation the monitor photodiode is exposed to if the monitor photodiode is in use. The invention also relates to a photonic integrated circuit (PIC) comprising the monitor photodiode according to the invention. The invention further relates to an opto-electronic system comprising a PIC according to the invention. The opto-electronic system according to the invention can be used for example, but not exclusively, for telecommunication applications, Light Detection and Ranging (LIDAR) or sensor applications. The invention even further relates to a method for fabricating the monitor photodiode according to the invention.

### BACKGROUND OF THE INVENTION

In many opto-electronic systems that can be used for example, but not exclusively, for telecommunication applications, Light Detection and Ranging (LIDAR) or sensor applications, a monitor photodiode is used for accurately measuring optical output radiation of a semiconductor laser for example for optical monitoring and/or control purposes. For efficiency reasons the monitor photodiode should typically absorb or tap at most 5% of the optical output radiation of the semiconductor laser, i.e. an amount of optical radiation that is just sufficient for establishing an electrical signal that can still reliably be measured by sensitive electronics. Tapping or absorbing more than 5% of optical radiation the monitor photodiode is exposed to can lead to additional insertion loss.

Known fabrication platforms for fabricating photonic integrated components, such as the above-mentioned monitor photodiode and/or PICs comprising such components, do not yet offer a performance, for example in terms of lithographic resolution, that can be achieved by known fabrication platforms for electronic integrated components. A consequence of a lithographic resolution limitation of known fabrication platforms for photonic integrated components is that fabrication of the above-mentioned monitor photodiode that is capable of absorbing at most 5% of optical radiation the monitor photodiode is exposed to, and for example an RF photodiode that is capable of absorbing 50% to 80% of the optical radiation the RF photodiode is exposed to, cannot be done using a same sequence of processing steps. As a result of the lithographic resolution limitation and the significant difference in functionality of the monitor photodiode and the RF photodiode, these components have different architectures. Because of the different architectures, the respective fabrication processes for the monitor photodiode and the RF photodiode have a different number of processing steps and/or a different kind of processing steps. Because of the many different fabrication processes that need to be supported by fabrication platforms that allow fabrication of a wide variety of photonic components having a wide variety of functionalities and/or performance characteristics, manageability of such fabrication platforms is complex. Therefore, there is a need for improving the manageability of such fabrication platforms by reducing the number of different fabrication processes required.

### SUMMARY OF THE INVENTION

It is an object of the present invention to provide a monitor photodiode that can be fabricated using the same number of processing steps and/or the same kind of processing steps that enable the fabrication of a photodiode that has a significantly different functionality and/or performance, e.g. the above-mentioned RF photodiode. In this way, the monitor photodiode according to the present invention enables reducing the number of different fabrication processes required and thus enables improving the manageability of a fabrication platform that allows fabrication of a wide variety of photonic components that have a wide variety of functionalities and/or performance characteristics. In addition, the monitor photodiode according to the present invention can pre-empt or at least reduce other disadvantages associated with the above-mentioned known fabrication platforms, such as high lead times and high costs.

It is also an object of the present invention to provide a PIC comprising a monitor photodiode according to the invention.

It is another object of the present invention to provide an opto-electronic system comprising a PIC according to the invention. The opto-electronic system according to the invention can be used for example, but not exclusively, for telecommunication applications, LIDAR or sensor applications.

It is yet another object of the present invention to provide a method for fabricating a monitor photodiode according to the invention.

Aspects of the present invention are set out in the accompanying independent and dependent claims. Features from the dependent claims may be combined with features from the independent claim as appropriate and not merely as explicitly set out in the claims. Furthermore, all features may be replaced with other technically equivalent features.

At least one of the abovementioned objects is achieved by a monitor photodiode for absorbing at most 5% of optical radiation to which the monitor photodiode is exposed if the monitor photodiode is in use, the monitor photodiode comprising a substrate having a first surface and a second surface that is arranged to face away from the first surface, and a layer stack that is arranged on the second surface of the substrate, the layer stack comprising:
- a semiconductor-based core layer having a third surface that is arranged to face towards the second surface of the substrate, and a fourth surface that is arranged to face away from the third surface, the semiconductor-based core layer being configured to guide optical radiation if the monitor photodiode is in use, the semiconductor-based core layer having a first surface area, A₁;
- a semiconductor-based absorption layer having a fifth surface that is arranged to face towards the second surface of the substrate, and a sixth surface that is arranged to face away from the fifth surface, the semiconductor-based absorption layer having:
   - a first width, W₁, seen in a direction transverse to a propagation direction, S, of the optical radiation that is present in the semiconductor-based core layer if the monitor photodiode is in use and parallel to the fourth surface of the semiconductor-based core layer; and
   - a first length, L₁, seen in the propagation direction, S, of the optical radiation that is present in the semiconductor-based core layer if the monitor photodiode is in use, the first length, L₁, being at least equal to 3µm;
   the semiconductor-based absorption layer having a second surface area, A₂ = W₁*L₁, that is smaller than the first surface area, A₁, of the semiconductor-based core layer; and
- a semiconductor-based cladding layer having a seventh surface that is arranged to face towards the second surface of the substrate, and an eighth surface that is arranged to face away from the seventh surface, the eighth surface being configured to have an elevated elongated portion that has:
   - a second width, W₂, seen in the direction transverse to the propagation direction, S, of the optical radiation that is present in the semiconductor-based core layer if the monitor photodiode is in use and parallel to the sixth surface of the semiconductor-based absorption layer; and
   - a second length, L₂, seen in the propagation direction, S, of the optical radiation that is present in the semiconductor-based core layer if the monitor photodiode is in use, the second length, L₂, being at least equal to the first length, L₁, of the semiconductor-based absorption layer;
   wherein the elevated elongated portion of the semiconductor-based cladding layer and the semiconductor-based absorption layer are arranged relative to each other in such a way that an overlap between a mode field, MF, of the optical radiation that is present in the semiconductor-based core layer if the monitor photodiode is in use and the semiconductor-based absorption layer results in an absorption of optical radiation of at most 5%.

As mentioned above, the manageability of a fabrication platform for fabricating photonic integrated components can be improved by reducing the number of different fabrication processes required for fabricating a wide variety of photonic components having a wide variety of functionalities and/or performance characteristics. In this way, the fabrication platform can offer as much functionality as possible with the least amount of processing steps. In order to achieve the latter, trade-offs are typically required. For example, a laser gain section and a SOA booster amplifier can achieve their best performances if the PL wavelengths for the laser gain section and the SOA booster amplifier are different from each other. This can be achieved at the expense of an additional epitaxial growth step, which adds to the complexity and costs of the fabrication process. However, by accepting a minor performance penalty for both the laser gain section and the SOA booster amplifier as a result of choosing the same PL wavelength for the laser gain section and the SOA booster amplifier, the additional epitaxial growth step can be avoided and thus the manageability of the fabrication platform as a whole can be improved.

A similar tradeoff can be envisioned regarding the fabrication of a monitor photodiode according to the present invention that is configured to absorb at most 5% of the optical radiation that the monitor photodiode is exposed to if the monitor photodiode is in use, and an RF photodiode that is configured to absorb 50% to 80% of the optical radiation the RF photodiode is exposed to if the RF photodiode is in use. Ideally, said RF photodiode has a semiconductor-based absorption layer that is configured to have a surface area that is as small as possible in order to provide the RF photodiode with an overall capacitance that is as low as possible, whereas the semiconductor-based absorption layer still allows absorption of 50% to 80% of the optical radiation the RF photodiode is exposed to if the RF photodiode is in use. The requirements regarding the surface area of the semiconductor-based absorption layer put limits on in particular length and width of the RF photodiode. If a fabrication process is used in which the width of the RF photodiode is for example fixed at 1.5µm, a suitable length of the RF photodiode needs to be established that allows absorption of 50% to 80% of the optical radiation the RF photodiode is exposed to if the RF photodiode is in use while keeping the overall capacitance of the RF photodiode as low as possible. If the RF photodiode has a responsivity of for example 0.8A/W, which equates to absorbing about 65% of the optical radiation the RF photodiode is exposed to if the RF photodiode is in use, the RF photodiode typically has a maximum length in the order of 25µm.

There are several options to achieve the RF photodiode and the monitor photodiode to have different optical tapping or absorbing performance. A first option to achieve absorbing or tapping of for example 1 % of the optical radiation that the monitor photodiode is exposed to, is to configure the monitor photodiode to have a length that is much shorter than the length of the aforementioned RF photodiode that has an exemplary width of 1.5µm and a maximum length in the order of 25µm. Preferably, the length of the monitor photodiode is as short as possible. The shortest possible length of the monitor photodiode is determined by a lithographic resolution limitation of the fabrication platform. Below the lithographic resolution limitation, the fabrication process is not reliable any more. In the event that the smallest possible length of the monitor photodiode, for example 5µm, is not small enough for achieving tapping or absorbing 1% of the optical radiation that the monitor photodiode is exposed to if the monitor photodiode is in use, other options can be explored.

If the RF photodiode has the aforementioned length, *L*, of for example 25µm and if the RF photodiode is required to absorb for example 65% of the optical radiation that the RF photodiode is exposed to if the RF photodiode is in use, it can be found by solving the equation 1 - exp(-*αL*) = 0.65 for absorption coefficient *α*, that the absorption coefficient *α* of the RF photodiode has a value of 420 cm⁻¹ (≈ 1825dB/cm). If the monitor photodiode has the aforementioned length, *L*, of for example 5µm and if the monitor photodiode is required to absorb for example 1% of the optical radiation that the monitor photodiode is exposed to, it can be found by solving the equation 1 - exp(-*αL*) = 0.01 for absorption coefficient *α,* that the absorption coefficient *α* of the monitor photodiode has a value of 20 cm⁻¹ (≈ 87dB/cm). Based on the large difference between the aforementioned values for the absorption coefficients *α* for the RF photodiode and the monitor photodiode respectively, it can be concluded that the semiconductor-based absorption layers of the RF photodiode and the monitor photodiode typically have different material compositions and/or are arranged at different distances from the respective semiconductor-based core layers for achieving optimal performances of the RF photodiode and the monitor photodiode. Moreover, it will be clear that any choice for a value of the absorption coefficient *α* in between the above-mentioned values in order to arrive at a trade-off regarding the absorption coefficient *α* for the monitor photodiode and the RF photodiode would lead to a performance penalty for at least one of the monitor photodiode and the RF photodiode.

A second option to achieve the aforementioned values for absorption coefficients *α* that enable the desired performances of the RF photodiode and the monitor photodiode, is to provide the RF photodiode and the monitor photodiode with semiconductor-based absorption layers having different material compositions. As a result, the fabrication process used for fabricating the RF photodiode and the fabrication process used for fabricating the monitor photodiode each require different epitaxial growth steps for realizing the different material compositions for the semiconductor-based absorption layers of the RF photodiode and the monitor photodiode, respectively. It will be clear that as a result of the different epitaxial growth steps, the RF photodiode and the monitor photodiode cannot be fabricated using the same fabrication process.

A third option to achieve the aforementioned values for absorption coefficients *α* that enable the desired performances of the RF photodiode and the monitor photodiode, is to provide the RF photodiode and the monitor photodiode with semiconductor-based absorption layers having a same material composition. Even in this case, different epitaxial growth steps are required for fabricating the semiconductor-based absorption layers of the RF photodiode and the monitor photodiode respectively, because a different overlap is required between the semiconductor-based absorption layer of the RF photodiode and the mode field of the optical radiation that is present in the semiconductor-based core layer of the RF photodiode, and between the semiconductor-based absorption layer of the monitor photodiode and the mode field of the optical radiation that is present in the semiconductor-based core layer of the monitor photodiode. The different overlaps can be achieved by arranging the semiconductor-based absorption layer and the semiconductor-based core layer of the RF photodiode at a first distance relative to each other and the semiconductor-based absorption layer and the semiconductor-based core layer of the monitor photodiode at a second distance relative to each other. It will be clear that the first distance and the second distance must be different from each other to achieve the aforementioned exemplary values for the desired absorption of the RF photodiode and the monitor photodiode, respectively. The person skilled in the art will appreciate that the second distance is considerably larger than the first distance for limiting the overlap between the semiconductor-based absorption layer of the monitor photodiode and the mode field of the optical radiation that is present in the semiconductor-based core layer of the monitor photodiode if the monitor photodiode is in use in order to achieve absorbing or tapping 1% of said optical radiation.

As a result of having to use different epitaxial growth steps for fabricating the semiconductor-based absorption layers of the RF photodiode and the monitor photodiode respectively, the complexity of the fabrication platform is increased and the manageability of the fabrication platform is decreased.

By patterning the semiconductor-based absorption layer of the monitor photodiode according to the present invention it is possible to fabricate a monitor photodiode that can absorb at most 5% of the optical radiation to which the monitor photodiode is exposed if the monitor photodiode is in use, and an RF photodiode that can absorb 50% to 80% of the optical radiation to which the RF photodiode is exposed if the RF photodiode is in use using a fabrication process that comprises the same processing steps. It is noted that the absorption of the monitor photodiode can be varied by adjusting the second surface area, A₂, of the semiconductor-based absorption layer and/or the arrangement of the elevated elongated portion of the semiconductor-based cladding layer and the semiconductor-based absorption layer with respect to each other. If the second surface, A₂, of the semiconductor-based absorption layer and the first surface area, A₁, of the semiconductor-based core layer are the same, the monitor photodiode will in fact be configured as an RF photodiode that is capable of absorbing 50% to 80% of the optical radiation that the RF photodiode is exposed to if the RF photodiode is in use.

Based on the above, the monitor photodiode according to the present invention allows reducing the number of different fabrication processes of the fabrication platform that is used for fabricating the above-mentioned monitor photodiode and RF photodiode having a significantly different desired performance. Consequently, the monitor photodiode according to the present invention allows improving the manageability of a fabrication platform that allows fabrication of a wide variety of photonic components that have a wide variety of functionalities and/or performance characteristics.

In an embodiment of the monitor photodiode according to the invention, the second width, W₂, of the elevated elongated portion is in a range from 200nm to 10µm and the first width, W₁, of the semiconductor-based absorption layer is in a range from 0.1·W₂ to 0.5·W₂. In this way, the overlap between the semiconductor-based absorption layer of the monitor photodiode and the mode field of the optical radiation that is present in the semiconductor-based core layer of the monitor photodiode if the monitor photodiode is in use can be adjusted to allow the monitor photodiode to absorb or tap at most 5% of optical radiation to which the monitor photodiode is exposed if the monitor photodiode is in use.

In an embodiment of the monitor photodiode according to the invention, the semiconductor-based absorption layer is provided with a slot that is configured and arranged to divide the semiconductor absorption layer into a first portion and a second portion, the first portion and the second portion being separated from each other and spaced apart as seen in the direction transverse to the propagation direction, S, of the optical radiation that is present in the semiconductor-based core layer if the monitor photodiode is in use and parallel to the second surface of the substrate, the slot having:
- a third width, W₃, seen in the direction transverse to the propagation direction, S, of the optical radiation that is present in the semiconductor-based core layer if the monitor photodiode is in use and parallel to the fourth surface of the semiconductor-based core layer, the third width, W₃, being in a range from 0.95·W₂ to 3·W₂ depending on a desired value of the overlap between the mode field, MF, of the optical radiation that is present in the semiconductor-based core layer if the monitor photodiode is in use and at least one of the first portion and the second portion of the semiconductor-based absorption layer; and
- a third length, L₃, seen in the propagation direction, S, of the optical radiation that is present in the semiconductor-based core layer if the monitor photodiode is in use, the third length, L₃, being equal to the first length, L₁, of the semiconductor-based absorption layer.

By providing the semiconductor-based absorption layer with the above-defined slot another way is provided for controlling the overlap between the semiconductor-based absorption layer and the mode field of the optical radiation that is present in the semiconductor-based core layer of the monitor photodiode if the monitor photodiode is in use and thereby achieving that the monitor photodiode absorbs or taps at most 5% of the optical radiation that the monitor photodiode is exposed to if the monitor photodiode is in use.

The third width, W₃, of the slot can be chosen depending on the desired amount of optical absorption that is the result of the overlap between the mode field, MF, of the optical radiation that is present in the semiconductor-based core layer if the monitor photodiode is in use and at least one of the first portion and the second portion of the semiconductor-based absorption layer. The amount of optical absorption is given by the expression exp(-*αΓL*₁) in which *α* is the absorption coefficient of the semiconductor-based material constituting the absorption layer, i.e. the above-mentioned first portion and second portion, *Γ* the overlap between the semiconductor-based absorption layer, i.e. at least one of the above-mentioned first portion and second portion, and the mode field of the optical radiation that is present in the semiconductor-based core layer of the monitor photodiode if the monitor photodiode is in use, and *L*₁ the length of the semiconductor-based absorption layer, i.e. the above-mentioned first portion and second portion. As mentioned above, preferably *L*₁ is the smallest length that can reliably be realized by the fabrication platform used. The overlap *Γ* is a function of the second width, W₂, of the elevated elongated portion of the semiconductor-based cladding layer.

It is noted that it is not necessary to add a process step to the fabrication process for the monitor photodiode for providing the semiconductor-based absorption layer with the above-mentioned slot as the slot can be provided as part of the process step for removing the semiconductor-based absorption layer over any passive areas. Hence, the manageability of the fabrication platform is not reduced as a result of providing the semiconductor-based absorption layer with the above-mentioned slot.

In an embodiment of the monitor photodiode according to the invention, the layer stack comprises a semiconductor-based spacer layer that is arranged between the semiconductor-based core layer and the semiconductor-based absorption layer, the semiconductor-based spacer layer having a ninth surface that is arranged to face towards the fourth surface of the semiconductor-based core layer, and a tenth surface that is arranged to face away from the ninth surface, the semiconductor spacer layer having a third surface area, A₃, that is equal to the first surface area, A₁, of the semiconductor-based core layer, the semiconductor-based spacer layer having a first thickness, T₁, seen in a direction transverse to the ninth surface, the first thickness, T₁, being in a range from 40nm to 100nm. The semiconductor-based spacer layer provides an additional degree of freedom for controlling the overlap between the semiconductor-based absorption layer and the mode field of the optical radiation that is present in the semiconductor-based core layer of the monitor photodiode if the monitor photodiode is in use. Experiments have shown that by choosing the thickness, T₁, of the semiconductor-based spacer layer in the above-mentioned range, an exemplary RF photodiode having a length of 25µm and a width of 1.5µm that allows absorption of 50% to 80% of the optical radiation to which the exemplary RF photodiode is exposed if the exemplary RF photodiode is in use, and an exemplary monitor photodiode having a length of 5µm and a width of 1.5µm that allows absorption or tapping of at most 5% of the optical radiation that the exemplary monitor photodiode is exposed to if the exemplary monitor photodiode is in use. It is noted that the exemplary RF photodiode and the exemplary monitor photodiode can be fabricated using the same fabrication process.

In an embodiment of the monitor photodiode according to the invention, the semiconductor-based spacer layer is a p-type doped InP-based layer. The p-type doped InP-based spacer layer can be configured to be optically transparent for the optical radiation that is present in the semiconductor-based core layer if the monitor photodiode is in use.

In an embodiment of the monitor photodiode according to the invention, the substrate is an n-type doped InP-based layer.

In an embodiment of the monitor photodiode according to the invention, the semiconductor-based core layer is a non-intentionally doped InₓGa₁₋ₓAs_{y}P_{1-y} layer. The semiconductor-based core layer is configured to guide the optical radiation that is present in it if the monitor photodiode is in use.

In an embodiment of the monitor photodiode according to the invention, the semiconductor-based absorption layer has a second thickness, T₂, seen in a direction transverse to the fifth surface, the second thickness, T₂, being in a range from 75nm to 150nm.

In an embodiment of the monitor photodiode according to the invention, the semiconductor-based absorption layer is a p-type doped or non-intentionally doped InₓGa₁₋ₓAs layer. The p-type doped or non-intentionally doped InₓGa₁₋ₓAs layer absorption layer can be configured to absorb the optical radiation that is present in the semiconductor-based core layer if the monitor photodiode is in use. Experiments have shown that such a p-type doped or non-intentionally doped InₓGa₁₋ₓAs absorption layer having a thickness, T₂, of 100nm allows an exemplary RF photodiode having a length of 25µm and a width of 1.5µm to absorb 65% of the optical radiation to which the exemplary RF photodiode is exposed if the exemplary RF photodiode is in use, whereas said p-type doped or non-intentionally doped InₓGa₁₋ₓAs absorption layer allows an exemplary monitor photodiode having a length of 5µm and a width of 1.5µm to absorb or tap 1 % of the optical radiation that the exemplary monitor photodiode is exposed to if the exemplary monitor photodiode is in use. It is noted that the exemplary RF photodiode and the exemplary monitor photodiode can be fabricated using the same fabrication process.

In an embodiment of the monitor photodiode according to the invention, the semiconductor-based cladding layer is a p-type doped InP-based layer. The p-type doped InP-based cladding layer can be configured to be optically transparent for the optical radiation that is present in the semiconductor-based core layer if the monitor photodiode is in use.

It is noted that the p-type doped InP-based cladding layer can be used to fill the slot that is provided in the semiconductor-based absorption layer that can be a p-type doped or non-intentionally doped InₓGa₁₋ₓAs layer as mentioned above.

According to another aspect of the present invention, a PIC is provided comprising a monitor photodiode according to the invention, wherein the PIC is a hybrid integrated PIC or a monolithic integrated PIC. Based on the above, the person skilled in the art will appreciate that the PIC according to the invention can benefit from the advantages provided by the monitor photodiode according to the present invention.

An advantage of a hybrid integrated PIC is that the monitor photodiode can be an InP-based monitor photodiode that is combined with for example Si-based opto-electronic devices. Hence, the PIC according to the present invention can be used in any semiconductor technology domain such as in the domain of silicon photonics.

Another advantage of a hybrid integrated PIC according to the invention is that the monitor photodiode can be exchanged. Exchange of the monitor photodiode can be required for example in case of malfunction of the monitor photodiode or after breakdown of the monitor photodiode.

An advantage of a monolithic integrated PIC is that both active and passive opto-electronic devices can be integrated on the same semiconductor substrate, e.g. an InP-based substrate. Moreover, monolithic integration of active and passive optoelectronics devices can be less cumbersome and possibly requires less die area than hybrid integration of active and passive opto-electronic devices.

According to another aspect of the present invention, an opto-electronic system is provided comprising a PIC according to the invention, wherein the opto-electronic system is one of a transmitter, a receiver, a transceiver, a coherent transmitter, a coherent receiver and a coherent transceiver. The opto-electronic system can for example, but not exclusively, be used for telecommunication applications, LIDAR or sensor applications. Based on the above, the person skilled in the art will appreciate that any one of the above-mentioned transmitters, receivers and transceivers can benefit from the advantages provided by the PIC according to the present invention that comprises the monitor photodiode according to the present invention.

According to another aspect of the present invention, a method is provided for fabricating a monitor photodiode for absorbing at most 5% of optical radiation to which the monitor photodiode is exposed if the monitor photodiode is in use, the method comprising:
- providing a substrate having a first surface and a second surface that is arranged to face away from the first surface;
- providing a layer stack on the second surface of the substrate, wherein providing the layer stack comprises:
   - epitaxially growing a semiconductor-based core layer that has a third surface that is arranged to face towards the second surface of the substrate, and a fourth surface that is arranged to face away from the third surface, the semiconductor-based core layer being configured to guide optical radiation if the monitor photodiode is in use, the semiconductor-based core layer having a first surface area, A₁;
   - epitaxially growing a semiconductor-based absorption layer that has a fifth surface that is arranged to face towards the second surface of the substrate, and a sixth surface that is arranged to face away from the fifth surface;
   - performing a first lithographic process and a subsequent first etching process to configure the semiconductor-based absorption layer to have:
      ▪ a first width, W₁, seen in a direction transverse to a propagation direction, S, of the optical radiation that is present in the semiconductor-based core layer if the monitor photodiode is in use and parallel to the fourth surface of the semiconductor-based core layer; and
      ▪ a first length, L₁, seen in the propagation direction, S, of the optical radiation that is present in the semiconductor-based core layer if the monitor photodiode is in use, the first length, L₁, being at least equal to 3µm;
      the semiconductor-based absorption layer having a second surface area, A₂ = W₁*L₁, that is smaller than the first surface area, A₁, of the semiconductor-based core layer;
   - epitaxially growing a semiconductor-based cladding layer that has a seventh surface that is arranged to face towards the second surface of the substrate, and an eighth surface that is arranged to face away from the seventh surface;
   - performing a second lithographic process and a subsequent second etching process to configure the eighth surface of the semiconductor-based cladding layer to have an elevated elongated portion that has:
      ▪ a second width, W₂, seen in the direction transverse to the propagation direction, S, of the optical radiation that is present in the semiconductor-based core layer if the monitor photodiode is in use and parallel to the sixth surface of the semiconductor-based absorption layer; and
      ▪ a second length, L₂, seen in the propagation direction, S, of the optical radiation that is present in the semiconductor-based core layer if the monitor photodiode is in use, the second length, L₂, being at least equal to the first length, L₁, of the semiconductor-based absorption layer;
      the elevated elongated portion of the semiconductor-based cladding layer and the semiconductor-based absorption layer being arranged relative to each other in such a way that an overlap between a mode field, MF, of the optical radiation that is present in the semiconductor-based core layer if the monitor photodiode is in use and the semiconductor-based absorption layer results in an absorption of optical radiation of at most 5%.

In this way, a first exemplary embodiment of the monitor photodiode according to the present invention can be fabricated that enables the above-mentioned advantages.

In an embodiment of the method according to the invention, the first lithographic process and the subsequent first etching process are performed to provide the semiconductor-based absorption layer with a slot that is configured and arranged to divide the semiconductor absorption layer into a first portion and a second portion, the first portion and the second portion being separated from each other and spaced apart as seen in the direction transverse to the propagation direction, S, of the optical radiation that is present in the semiconductor-based core layer if the monitor photodiode is in use and parallel to the second surface of the substrate, the slot having:
- a third width, W₃, seen in the direction transverse to the propagation direction, S, of the optical radiation that is present in the semiconductor-based core layer if the monitor photodiode is in use and parallel to the fourth surface of the semiconductor-based core layer, the third width, W₃, being in a range from 0.95·W₂ to 3·W₂ depending on a desired value of the overlap between the mode field, MF, of the optical radiation that is present in the semiconductor-based core layer if the monitor photodiode is in use and at least one of the first portion and the second portion of the semiconductor-based absorption layer; and
- a third length, L₃, seen in the propagation direction, S, of the optical radiation that is present in the semiconductor-based core layer if the monitor photodiode is in use, the third length, L₃, being equal to the first length, L₁, of the semiconductor-based absorption layer.

In this way, a second exemplary embodiment of the monitor photodiode according to the present invention can be fabricated that enables the above-mentioned advantages.

In an embodiment of the method according to the invention, providing the layer stack comprises epitaxially growing a semiconductor-based spacer layer after epitaxially growing the semiconductor-based core layer and before growing the semiconductor-based absorption layer, the semiconductor-based spacer layer having a ninth surface that is arranged to face towards the fourth surface of the semiconductor-based core layer, and a tenth surface that is arranged to face away from the ninth surface, the semiconductor spacer layer having a third surface area, A₃, that is equal to the first surface area, A₁, of the semiconductor-based core layer.

As mentioned above, the semiconductor-based spacer layer provides an additional degree of freedom for controlling the overlap between the semiconductor-based absorption layer and the mode field of the optical radiation that is present in the semiconductor-based core layer of the monitor photodiode if the monitor photodiode is in use. The semiconductor-based spacer layer can be a p-type doped InP-based layer that can be configured to be optically transparent for the optical radiation that is present in the semiconductor-based core layer if the monitor photodiode is in use.

### BRIEF DESCRIPTION OF THE DRAWINGS

Further features and advantages of the invention will become apparent from the description of exemplary and non-limiting embodiments of a monitor photodiode, a PIC, an opto-electronic system, and a method for fabricating a monitor photodiode according to the present invention.

The person skilled in the art will appreciate that the described embodiments of the monitor photodiode, the PIC, the opto-electronic system, and the method for fabricating the monitor photodiode are exemplary in nature only and not to be construed as limiting the scope of protection in any way. The person skilled in the art will realize that alternatives and equivalent embodiments of the monitor photodiode, the PIC, the opto-electronic system, and the method for fabricating the monitor photodiode can be conceived and reduced to practice without departing from the scope of protection of the present invention.

Reference will be made to the figures on the accompanying drawing sheets. The figures are schematic in nature and therefore not necessarily drawn to scale. Furthermore, equal reference numerals denote equal or similar parts. On the attached drawing sheets,
figure 1A shows a schematic top view of a first exemplary, non-limiting embodiment of the monitor photodiode according to the present invention;
figure 1B shows a schematic cross-sectional view of the first exemplary, non-limiting embodiment of the monitor photodiode along line A-B as indicated in figure 1A;
figure 2A shows a schematic top view of a second exemplary, non-limiting embodiment of the monitor photodiode according to the present invention;
figure 2B shows a schematic cross-sectional view of the second exemplary, non-limiting embodiment of the monitor photodiode along line A-B as indicated in figure 2A;

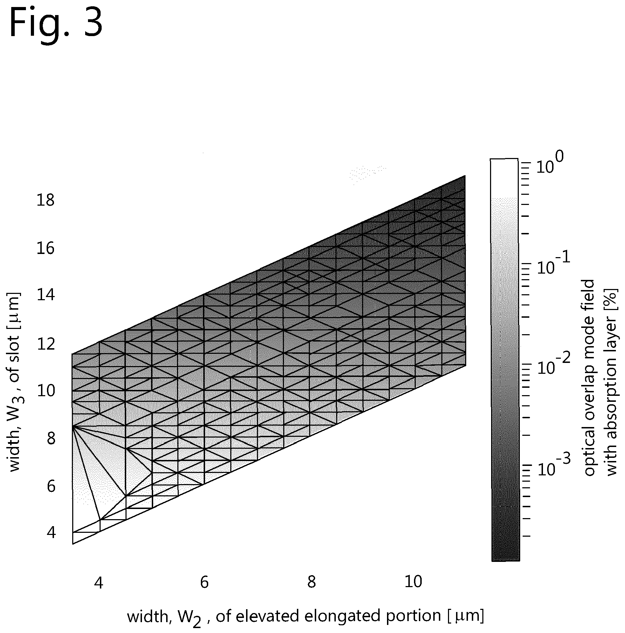

figure 3 shows a simulation of a value of an optical overlap between a semiconductor-based absorption layer of a monitor photodiode in accordance with the second exemplary, non-limiting embodiment of the monitor photodiode, and a mode field of optical radiation that is present in a semiconductor-based core layer of the monitor photodiode if the monitor photodiode is in use, wherein the value of the optical overlap depends on a value for a second width, W₂, of an elevated elongated portion of a semiconductor-based cladding layer of the monitor photodiode and a third width, W₃, of a slot that is provided to the semiconductor-based absorption layer;
figure 4 shows a schematic top view of a first exemplary, non-limiting embodiment of a PIC according to the present invention that comprises the monitor photodiode according to the present invention;
figure 5 shows a schematic top view of a first exemplary, non-limiting embodiment of an opto-electronic system according to the present invention that comprises the PIC according to the present invention; and
figure 6A shows a flow diagram of a first exemplary, non-limiting embodiment of a method for fabricating a monitor photodiode according to the present invention;
figure 6B shows a flow diagram of a second exemplary, non-limiting embodiment of the method for fabricating the monitor photodiode according to the present invention;
figure 6C shows a flow diagram of a third exemplary, non-limiting embodiment of the method for fabricating the monitor photodiode according to the present invention; and
figure 6D shows a flow diagram of a fourth exemplary, non-limiting embodiment of the method for fabricating the monitor photodiode according to the present invention.

### DETAILED DESCRIPTION OF EMBODIMENTS

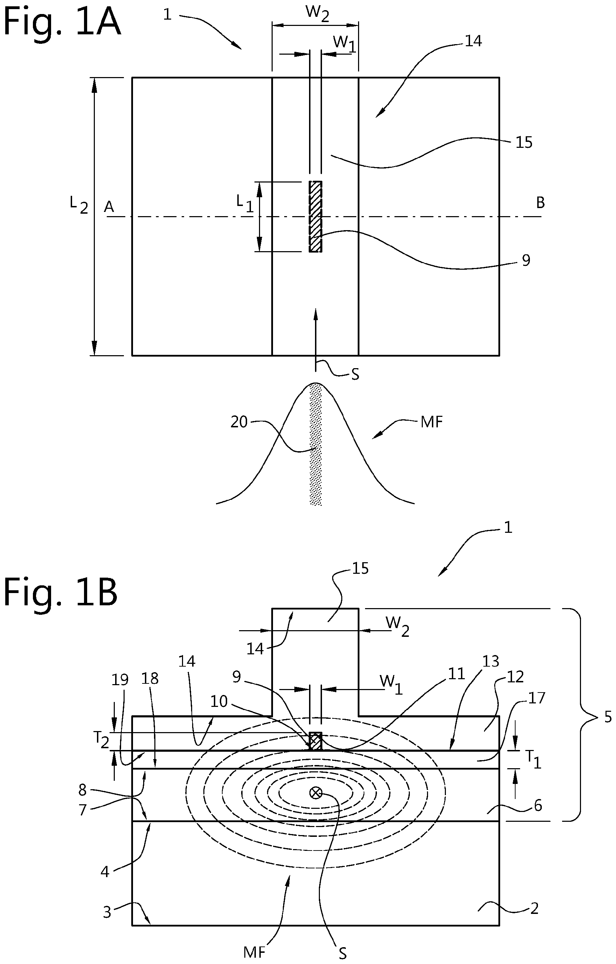

Figure 1A shows a schematic top view of a first exemplary, non-limiting embodiment of a monitor photodiode 1 for absorbing at most 5% of optical radiation to which the monitor photodiode 1 is exposed if the monitor photodiode 1 is in use according to the present invention, whereas figure 1B shows a schematic cross-sectional view of the first exemplary, non-limiting embodiment of the monitor photodiode 1 along line A-B as indicated in figure 1A.

The monitor photodiode 1 comprises a substrate 2 having a first surface 3 and a second surface 4 that is arranged to face away from the first surface 3, and a layer stack 5 that is arranged on the second surface 4 of the substrate 2. The substrate 2 can be an n-type doped InP-based layer.

The layer stack 5 comprises a semiconductor-based core layer 6 having a third surface 7 that is arranged to face towards the second surface 4 of the substrate 2 and to be in contact with the second surface 4. The semiconductor-based core layer 6 also has a fourth surface 8 that is arranged to face away from the third surface 7. The semiconductor-based core layer 6 has a first surface area, A₁, and is configured to guide optical radiation if the monitor photodiode 1 is in use. A mode field, MF, and a propagation direction, S, of the optical radiation are schematically indicated in figures 1A and 1B. The semiconductor-based core layer 6 can be a non-intentionally doped InₓGa₁₋ₓAs_{y}P_{1-y} layer that can be configured to guide the optical radiation that is present in it if the monitor photodiode 1 is in use.

In accordance with the first exemplary, non-limiting embodiment of the monitor photodiode 1 shown in figures 1A and 1B, the layer stack 5 comprises a semiconductor-based spacer layer 17 having a ninth surface 18 that is arranged to face towards the fourth surface 8 of the semiconductor-based core layer 6 and to be in contact with the fourth surface 8. The semiconductor-based spacer layer 17 also has a tenth surface 19 that is arranged to face away from the ninth surface 18. The semiconductor spacer layer 17 has a third surface area, A₃, that is equal to the first surface area, A₁, of the semiconductor-based core layer 6. The semiconductor-based spacer layer 17 has a first thickness, T₁, seen in a direction transverse to the ninth surface 18. The first thickness, T₁, is in a range from 40nm to 100nm. The semiconductor-based spacer layer 17 can be a p-type doped InP-based layer that can be configured to be optically transparent for the optical radiation that is present in the semiconductor-based core layer 6 if the monitor photodiode 1 is in use.

The layer stack 5 comprises a semiconductor-based absorption layer 9 having a fifth surface 10 that is arranged to face towards the tenth surface 19 of the semiconductor-based spacer layer 17 and to be in contact with the tenth surface 19. The semiconductor-based absorption layer 9 also has a sixth surface 11 that is arranged to face away from the fifth surface 10. The semiconductor-based absorption layer 9 has a first width, W₁, seen in a direction transverse to the propagation direction, S, of the optical radiation that is present in the semiconductor-based core layer 6 if the monitor photodiode 1 is in use and parallel to the fourth surface 8 of the semiconductor-based core layer 6. The semiconductor-based absorption layer 9 has a first length, L₁, seen in the propagation direction, S, of the optical radiation that is present in the semiconductor-based core layer 6 if the monitor photodiode 1 is in use. The first length, L₁, is at least equal to 3µm. The semiconductor-based absorption layer 9 has a second surface area, A₂ = W₁*L₁, that is smaller than the first surface area, A₁, of the semiconductor-based core layer 6. The semiconductor-based absorption layer 9 has a second thickness, T₂, seen in a direction transverse to the fifth surface 10. The second thickness, T₂, is in a range from 75nm to 150nm. The semiconductor-based absorption layer 9 can be a p-type doped or non-intentionally doped InₓGa₁₋ₓAs layer that can be configured to absorb the optical radiation that is present in the semiconductor-based core layer 6 if the monitor photodiode 1 is in use.

The layer stack 5 comprises a semiconductor-based cladding layer 12 having a seventh surface 13 that is arranged to face towards the second surface 4 of the substrate 2 and to be in contact with the tenth surface 19 of the semiconductor-based spacer layer 17 and the sixth surface 11 of the semiconductor-based absorption layer 9. The semiconductor-based cladding layer 12 also has an eighth surface 14 that is arranged to face away from the seventh surface 13. The eighth surface 14 is configured to have an elevated elongated portion 15 that has a second width, W₂, seen in the direction transverse to the propagation direction, S, of the optical radiation that is present in the semiconductor-based core layer 6 if the monitor photodiode 1 is in use and parallel to the sixth surface 11 of the semiconductor-based absorption layer 9. The elevated elongated portion 15 has a second length, L₂, seen in the propagation direction, S, of the optical radiation that is present in the semiconductor-based core layer 6 if the monitor photodiode 1 is in use. The second length, L₂, is at least equal to the first length, L₁, of the semiconductor-based absorption layer 9.

The elevated elongated portion 15 of the semiconductor-based cladding layer 12 and the semiconductor-based absorption layer 9 are arranged relative to each other in such a way that an overlap between the mode field, MF, of the optical radiation that is present in the semiconductor-based core layer 6 if the monitor photodiode 1 is in use and the semiconductor-based absorption layer 9 results in an absorption of optical radiation of at most 5%. It is noted that the second width, W₂, of the elevated elongated portion 15 of the semiconductor-based cladding layer 12 is in a range from 200nm to 10µm and the first width, W₁, of the semiconductor-based absorption layer 9 is in a range from 0.1·W₂ to 0.5·W₂. In this way, the overlap between the semiconductor-based absorption layer 9 and the mode field, MF, of the optical radiation that is present in the semiconductor-based core layer 6 if the monitor photodiode 1 is in use can be adjusted to allow the monitor photodiode 1 to absorb or tap at most 5% of optical radiation to which the monitor photodiode is exposed if the monitor photodiode 1 is in use.

It is noted that the semiconductor-based spacer layer 17 provides an additional degree of freedom for controlling the overlap between the semiconductor-based absorption layer 9 and the mode field, MF, of the optical radiation by choosing a suitable value for the first thickness, T₁, of the semiconductor-based spacer layer 17 out of the range from 40nm to 100nm.

The semiconductor-based cladding layer 12 can be a p-type doped InP-based layer that can be configured to be optically transparent for the optical radiation that is present in the semiconductor-based core layer 6 if the monitor photodiode 1 is in use.

A part 20 of the mode field, MF, that corresponds with the desired overlap between the mode field, MF, and semiconductor-based absorption layer 9 is indicated in the mode field, MF schematically shown in figure 1A. Regarding figure 1A, it is noted that the semiconductor-based absorption layer 9, which would not be visible in the top view of the monitor photodiode 1, is drawn using dashed lines as to give an impression of its dimensions and its position relative to the elevated elongated portion 15 of the semiconductor-based cladding layer 12.

As mentioned above, by patterning the semiconductor-based absorption layer 9 of the monitor photodiode 1, it is possible to fabricate a monitor photodiode that can absorb at most 5% of the optical radiation to which the monitor photodiode is exposed if the monitor photodiode is in use, and an RF photodiode that can absorb 50% to 80% of the optical radiation to which the RF photodiode is exposed if the RF photodiode is in use using a fabrication process that comprises the same processing steps. It is noted that the absorption of the monitor photodiode 1 can be varied by adjusting the second surface area, A₂, of the semiconductor-based absorption layer 9 and/or the arrangement of the elevated elongated portion 15 of the semiconductor-based cladding layer 12 and the semiconductor-based absorption layer 9 with respect to each other. If the second surface, A₂, of the semiconductor-based absorption layer 9 and the first surface area, A₁, of the semiconductor-based core layer 6 are the same, the monitor photodiode 1 will in fact be configured as an RF photodiode that is capable of absorbing 50% to 80% of the optical radiation that the RF photodiode is exposed to if the RF photodiode is in use.

Based on the above, the monitor photodiode 1 allows reducing the number of different fabrication processes of the fabrication platform that is used for fabricating the above-mentioned monitor photodiode and RF photodiode having a significantly different desired performance. Consequently, the monitor photodiode 1 according to the present invention allows improving the manageability of a fabrication platform that allows fabrication of a wide variety of photonic components that have a wide variety of functionalities and/or performance characteristics.

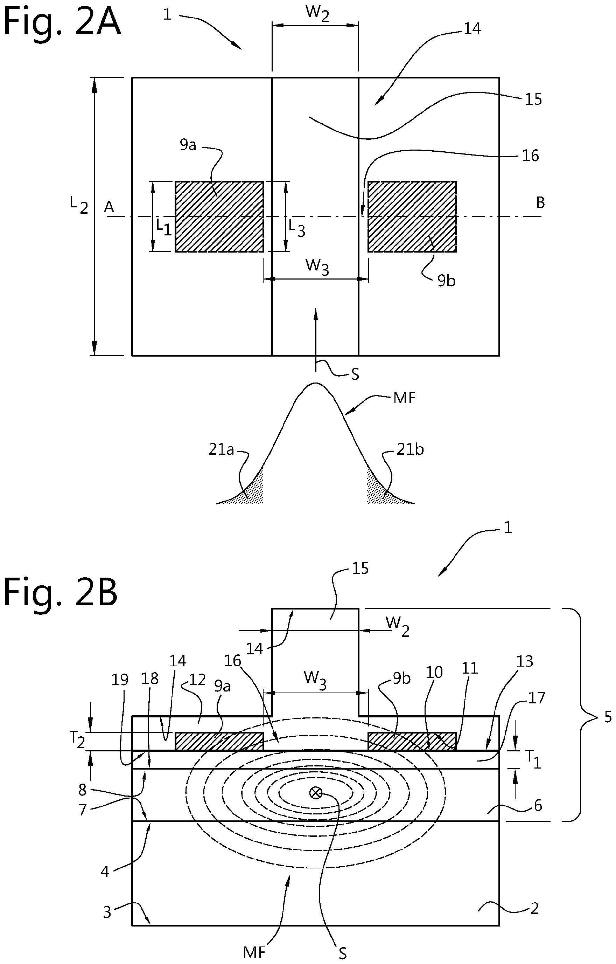

Figure 2A shows a schematic top view of a second exemplary, non-limiting embodiment of the monitor photodiode 1 according to the present invention, and figure 2B shows a schematic cross-sectional view of the second exemplary, non-limiting embodiment of the monitor photodiode 1 along line A-B as indicated in figure 2A. In accordance with the second exemplary, non-limiting embodiment of the monitor photodiode 1, the semiconductor-based absorption layer 9 is provided with a slot 16 that is configured and arranged to divide the semiconductor absorption layer 9 into a first portion 9a and a second portion 9b. The first portion 9a and the second portion 9b are separated from each other and spaced apart as seen in the direction transverse to the propagation direction, S, of the optical radiation that is present in the semiconductor-based core layer 6 if the monitor photodiode 1 is in use and parallel to the second surface 4 of the substrate 2. As mentioned above, the semiconductor-based core layer 6 can be a non-intentionally doped InₓGa₁₋ₓAs_{y}P_{1-y} layer.

The slot 16 has a third width, W₃, seen in the direction transverse to the propagation direction, S, of the optical radiation that is present in the semiconductor-based core layer 6 if the monitor photodiode 1 is in use and parallel to the fourth surface 8 of the semiconductor-based core layer 6. The third width, W₃, is in a range from 0.95·W₂ to 3·W₂ depending on a desired value of an optical overlap between the mode field, MF, of the optical radiation that is present in the semiconductor-based core layer 6 if the monitor photodiode 1 is in use and at least one of the first portion 9a and the second portion 9b of the semiconductor-based absorption layer 9. The third width, W₃, of the slot 16 can be chosen depending on the desired amount of optical absorption that is the result of the above-mentioned optical overlap. The amount of optical absorption is given by the expression exp(-*αΓL*₁) in which *α* is the absorption coefficient of the semiconductor-based material, e.g. p-type doped or non-intentionally doped InₓGa₁₋ₓAs, constituting the absorption layer 9, i.e. the above-mentioned first portion 9a and second portion 9b, *Γ* the optical overlap between the semiconductor-based absorption layer 9, i.e. at least one of the above-mentioned first portion 9a and second portion 9b, and the mode field of the optical radiation that is present in the semiconductor-based core layer 6 of the monitor photodiode 1 if the monitor photodiode 1 is in use, and *L*₁ the length of the semiconductor-based absorption layer 9, i.e. the above-mentioned first portion 9a and second portion 9b. As mentioned above, preferably *L*₁ is the smallest length that can reliably be realized by the fabrication platform used. The optical overlap *Γ* is a function of the second width, W₂, of the elevated elongated portion 15 of the semiconductor-based cladding layer 12.

The slot 16 has a third length, L₃, seen in the propagation direction, S, of the optical radiation that is present in the semiconductor-based core layer 6 if the monitor photodiode 1 is in use. The third length, L₃, is equal to the first length, L₁, of the semiconductor-based absorption layer 9.

By providing the semiconductor-based absorption layer 9 with the slot 16 another way is provided for controlling the optical overlap between the semiconductor-based absorption layer 9, i.e. at least one of the first portion 9a and second portion 9b, and the mode field, MF, of the optical radiation that is present in the semiconductor-based core layer 6 of the monitor photodiode 1 if the monitor photodiode 1 is in use and thereby achieving that the monitor photodiode 1 absorbs or taps at most 5% of the optical radiation that the monitor photodiode 1 is exposed to if the monitor photodiode 1 is in use.

It is noted that it is not necessary to add a process step to the fabrication process for the monitor photodiode 1 for providing the semiconductor-based absorption layer 9 with the slot 16 as the slot 16 can be provided as part of a process step for removing the semiconductor-based absorption layer 9 over any passive areas (not shown). Hence, the manageability of the fabrication platform is not reduced as a result of providing the semiconductor-based absorption layer 9 with the slot 16.

In addition, it is noted that in accordance with the second exemplary, non-limiting embodiment of the monitor photodiode 1, the cladding layer 12, which can be a p-type doped InP-based layer, is used to fill the slot 16 and is in contact with the tenth surface 19 of the semiconductor-based spacer layer 17, which can also be a p-type doped InP-based layer.

Figure 3 shows a simulation of a value of the optical overlap between at least one of the first portion 9a and the second portion 9b of the semiconductor-based absorption layer 9 of the monitor photodiode 1 in accordance with the second exemplary, non-limiting embodiment shown in figures 2A and 2B, and the mode field, MF, of the optical radiation that is present in the semiconductor-based core layer 6 of the monitor photodiode 1 if the monitor photodiode 1 is in use. The value of the optical overlap depends on the value for the second width, W₂, of the elevated elongated portion 15 of the semiconductor-based cladding layer 12 and the third width, W₃, of the slot 16 that is provided to the semiconductor-based absorption layer 9. Figure 3 illustrates that if a ratio W₃/W₂ equals 1, the above-mentioned optical overlap is at most 1%. By choosing a ratio W₃/W₂ that is larger than 1, the optical overlap can be reduced to values lower than 1%. In this way the optical absorption can also be reduced.

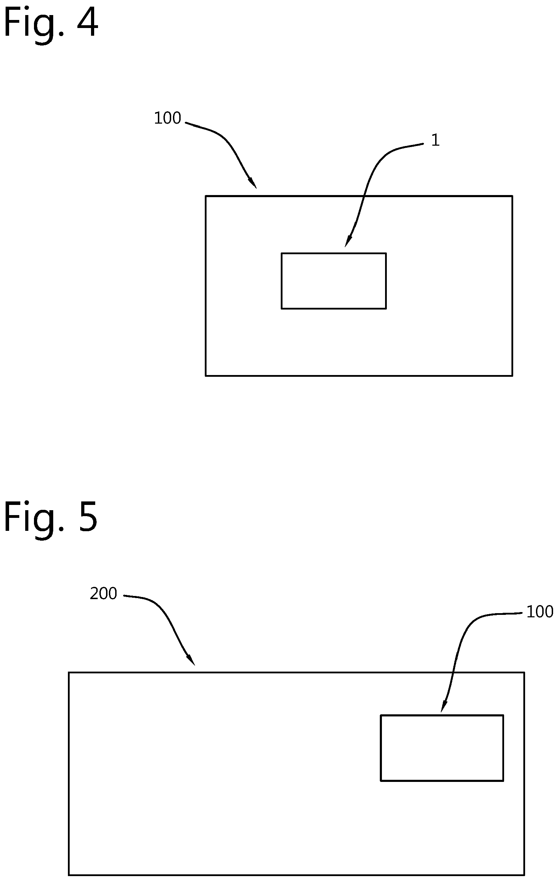

Figure 4 shows a schematic top view of a first exemplary, non-limiting embodiment of a PIC 100 according to the present invention that comprises the monitor photodiode 1 according to the present invention. The monitor photodiode 1 can be construed to be monolithically integrated with other opto-electronic devices (not shown) of the PIC 100.

In accordance with an exemplary, non-limiting embodiment of the PIC that is not shown, the monitor photodiode can be integrated in a hybrid way with other opto-electronic devices of the PIC. An advantage of enabling hybrid integration of the monitor photodiode according to the invention is that the monitor photodiode can be used in any semiconductor technology domain such as the domain of silicon photonics. Another advantage of enabling hybrid integration of the monitor photodiode according to the invention is that the monitor photodiode can be exchanged. Exchange of the monitor photodiode can be required for example in case of malfunction of the monitor photodiode or after breakdown of the monitor photodiode.

An advantage of monolithically integrating the monitor photodiode with other opto-electronic devices (not shown) on the same semiconductor substrate as schematically illustrated in figure 4, is that the monolithic integration of the monitor photodiode 1 and the other opto-electronic components can be less cumbersome and possibly requires less die area than the hybrid integration thereof. Consequently, the costs associated with monolithic integration of the active and the passive opto-electronic devices can be less than the costs associated with the hybrid integration thereof. In addition, monolithic integration can allow the PIC 100 to have a smaller footprint. This is beneficial for reducing the costs of the PIC.

The PIC 100 can be an InP-based PIC. The person skilled in the art will appreciate that the most versatile technology platform for PICs, especially for PICs that can be applied in telecommunication, LIDAR or sensor applications, uses wafers comprising InP-based semiconductor materials. InP-based technology enables monolithic integration of both active components such as for example light-generating and/or light-absorbing optical devices, and passive components such as for example light-guiding and/or light-switching optical devices, in one PIC on a single die.

Based on the above, the person skilled in the art will appreciate that the PIC 100 according to the invention can benefit from the advantages provided by the monitor photodiode 1 according to the present invention.

Figure 5 shows a schematic view of a first exemplary, non-limiting embodiment of an opto-electronic system 200 according to the present invention that comprises a PIC 100 according to the present invention. The opto-electronic system 200 can be used for example but not exclusively in telecommunication applications, LIDAR or sensor applications. The opto-electronic system 200 can for example be one of a transmitter, a receiver, a transceiver, a coherent transmitter, a coherent receiver and a coherent transceiver. Based on the above, the person skilled in the art will appreciate that the opto-electronic system 200 according to the present invention can benefit from the advantages provided by the PIC 100 according to the present invention.

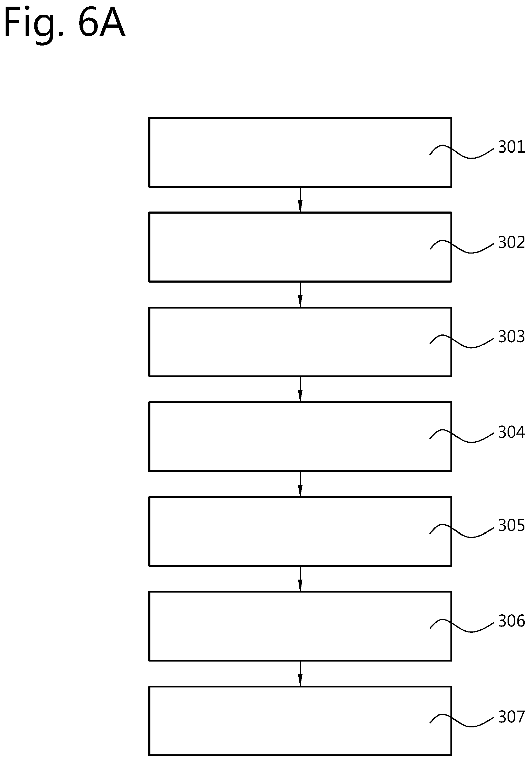

Figure 6A shows a flow diagram of a first exemplary, non-limiting embodiment of a method 300 for fabricating a monitor photodiode according to the present invention.

Step 301 comprises providing a substrate 2 having a first surface 3 and a second surface 4 that is arranged to face away from the first surface 3.

Step 302 comprises providing a layer stack 5 on the second surface 4 of the substrate 2, wherein providing the layer stack 5 comprises steps 303-307.

Step 303 comprises epitaxially growing a semiconductor-based core layer 6 that has a third surface 7 that is arranged to face towards the second surface 4 of the substrate 2, and a fourth surface 8 that is arranged to face away from the third surface 7, the semiconductor-based core layer 6 being configured to guide optical radiation if the monitor photodiode 1 is in use. The semiconductor-based core layer 6 has a first surface area, A₁.

Step 304 comprises epitaxially growing a semiconductor-based absorption layer 9 that has a fifth surface 10 that is arranged to face towards the second surface 4 of the substrate 2, and a sixth surface 11 that is arranged to face away from the fifth surface 10.

Step 305 comprises performing a first lithographic process and a subsequent first etching process to configure the semiconductor-based absorption layer 9 to have a first width, W₁, seen in a direction transverse to a propagation direction, S, of the optical radiation that is present in the semiconductor-based core layer 6 if the monitor photodiode 1 is in use and parallel to the fourth surface 8 of the semiconductor-based core layer 6, and a first length, L₁, seen in the propagation direction, S, of the optical radiation that is present in the semiconductor-based core layer 6 if the monitor photodiode 1 is in use, the first length, L₁, being at least equal to 3µm. The semiconductor-based absorption layer 9 has a second surface area, A₂ = W₁*L₁, that is smaller than the first surface area, A₁, of the semiconductor-based core layer 6.

Step 306 comprises epitaxially growing a semiconductor-based cladding layer 12 that has a seventh surface 13 that is arranged to face towards the second surface 4 of the substrate 2, and an eighth surface 14 that is arranged to face away from the seventh surface.

Step 307 comprises performing a second lithographic process and a subsequent second etching process to configure the eighth surface 14 of the semiconductor-based cladding layer 12 to have an elevated elongated portion 15 that has a second width, W₂, seen in the direction transverse to the propagation direction, S, of the optical radiation that is present in the semiconductor-based core layer 6 if the monitor photodiode 1 is in use and parallel to the sixth surface 11 of the semiconductor-based absorption layer (9), and a second length, L₂, seen in the propagation direction, S, of the optical radiation that is present in the semiconductor-based core layer 6 if the monitor photodiode 1 is in use, the second length, L₂, being at least equal to the first length, L₁, of the semiconductor-based absorption layer 9. The elevated elongated portion 15 of the semiconductor-based cladding layer 12 and the semiconductor-based absorption layer 9 being arranged relative to each other in such a way that an overlap between a mode field, MF, of the optical radiation that is present in the semiconductor-based core layer 6 if the monitor photodiode 1 is in use and the semiconductor-based absorption layer 9 results in an absorption of optical radiation of at most 5%.

By consecutively executing steps 301-307 of the first exemplary, non-limiting embodiment of the method 300, an exemplary, non-limiting embodiment of a monitor photodiode according to the present invention can be fabricated that allows absorbing at most 5% of the optical radiation to which the monitor photodiode is exposed if the monitor photodiode is in use, and enables the above-mentioned advantages.

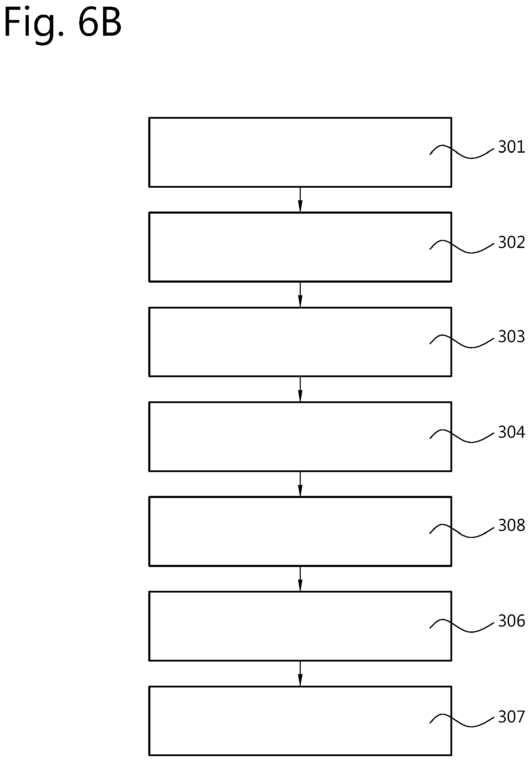

Figure 6B shows a flow diagram of a second exemplary, non-limiting embodiment of the method 300 for fabricating a monitor photodiode according to the present invention. It is noted that steps 301, 302, 303, 304, 306 and 307 are the same as mentioned above having regard to the first exemplary, non-limiting embodiment of the method 300 shown in figure 6A. In addition, it is noted that step 308 is performed instead of step 305 in accordance with the first exemplary, non-limiting embodiment of the method 300.

Step 308 comprises performing a first lithographic process and a subsequent first etching process to provide the semiconductor-based absorption layer 9 with a slot 16 that is configured and arranged to divide the semiconductor absorption layer 9 into a first portion 9a and a second portion 9b. The first portion 9a and the second portion 9b are separated from each other and spaced apart as seen in the direction transverse to the propagation direction, S, of the optical radiation that is present in the semiconductor-based core layer 6 if the monitor photodiode 1 is in use and parallel to the second surface 4 of the substrate 2. The slot 16 has a third width, W₃, seen in the direction transverse to the propagation direction, S, of the optical radiation that is present in the semiconductor-based core layer 6 if the monitor photodiode 1 is in use and parallel to the fourth surface 8 of the semiconductor-based core layer 6. The third width, W₃, is in a range from 0.95·W₂ to 3·W₂ depending on a desired value of the overlap between the mode field, MF, of the optical radiation that is present in the semiconductor-based core layer 6 if the monitor photodiode 1 is in use and at least one of the first portion 9a and the second portion 9b of the semiconductor-based absorption layer 9. The slot 16 has a third length, L₃, seen in the propagation direction, S, of the optical radiation that is present in the semiconductor-based core layer 6 if the monitor photodiode 1 is in use. The third length, L₃, is equal to the first length, L₁, of the semiconductor-based absorption layer 9.

By consecutively executing steps 301, 302, 303, 304, 308, 306 and 307 of the second exemplary, non-limiting embodiment of the method 300, another exemplary, non-limiting embodiment of the monitor photodiode according to the present invention can be fabricated that allows absorbing at most 5% of the optical radiation to which the monitor photodiode is exposed if the monitor photodiode is in use, and enables the above-mentioned advantages.

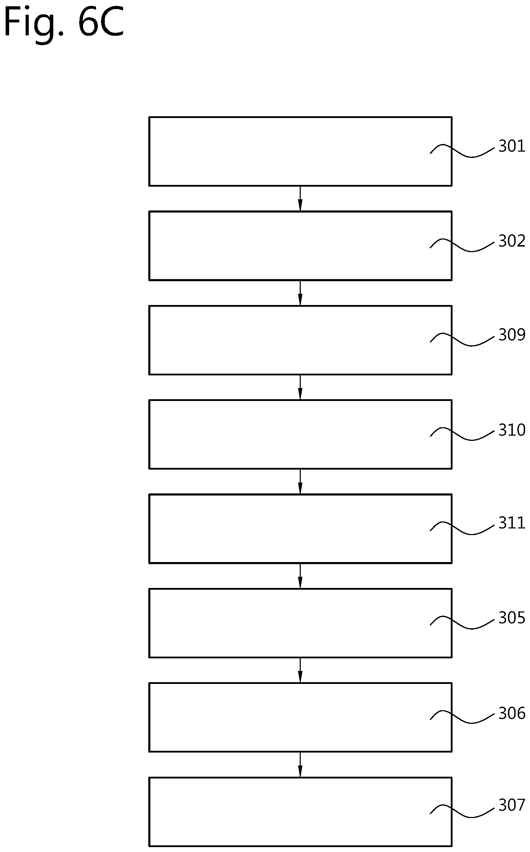

Figure 6C shows a flow diagram of a third exemplary, non-limiting embodiment of the method 300 for fabricating the monitor photodiode 1 according to the present invention. It is noted that steps 301, 302, 305, 306 and 307 are the same as mentioned above having regard to the first exemplary, non-limiting embodiment of the method 300 shown in figure 6A.

Step 309 comprises epitaxially growing a semiconductor-based core layer 6 having a third surface 7 that is arranged to face towards the second surface 4 of the substrate 2 and is in contact with the second surface 4. The semiconductor-based core layer 6 has a fourth surface 8 that is arranged to face away from the third surface 7. The semiconductor-based core layer 6 is configured to guide optical radiation if the monitor photodiode 1 is in use. The semiconductor-based core layer 6 has a first surface area, A₁.

Step 310 comprises epitaxially growing a semiconductor-based spacer layer 17 having a ninth surface 18 that is arranged to face towards the fourth surface 8 of the semiconductor-based core layer 6 and is in contact with the fourth surface 8. The semiconductor-based spacer layer 17 has a tenth surface 19 that is arranged to face away from the ninth surface 18. The semiconductor spacer layer 17 has a third surface area, A₃, that is equal to the first surface area, A₁, of the semiconductor-based core layer 6.

Step 311 comprises epitaxially growing a semiconductor-based absorption layer 9 that has a fifth surface 10 that is arranged to face towards the tenth surface 19 of the semiconductor-based spacer layer 17 and is in contact with the tenth surface 19. The semiconductor-based absorption layer 9 has a sixth surface 11 that is arranged to face away from the fifth surface 10.

By consecutively executing steps 301, 302, 309, 310, 311, 305, 306, 307 of the third exemplary, non-limiting embodiment of the method 300, yet another exemplary, non-limiting embodiment of the monitor photodiode according to the present invention can be fabricated that allows absorbing at most 5% of the optical radiation to which the monitor photodiode is exposed if the monitor photodiode is in use, and enables the above-mentioned advantages.

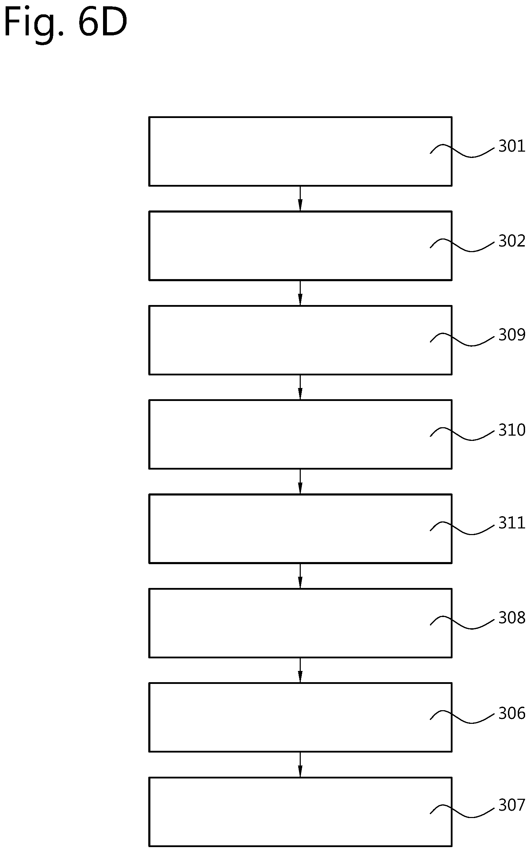

Figure 6D shows a flow diagram of a fourth exemplary, non-limiting embodiment of the method 300 for fabricating the monitor photodiode 1 according to the present invention. It is noted that steps 301, 302, 308, 306 and 307 are the same as mentioned above having regard to the second exemplary, non-limiting embodiment of the method 300 shown in figure 6B. Furthermore, steps 309, 310 and 311 are the same as mentioned above having regard to the third exemplary, non-limiting embodiment of the method 300 shown in figure 6C.

By consecutively executing steps 301, 302, 309, 310, 311, 308, 306 and 307 of the fourth exemplary, non-limiting embodiment of the method 300, yet another exemplary, non-limiting embodiment of the monitor photodiode according to the present invention can be fabricated that allows absorbing at most 5% of the optical radiation to which the monitor photodiode is exposed if the monitor photodiode is in use, and enables the above-mentioned advantages.

The present invention can be summarized as relating to a monitor photodiode 1 for absorbing at most 5% of optical radiation to which the monitor photodiode is exposed if the monitor photodiode is in use. The monitor photodiode comprises a layer stack 5 having a semiconductor-based core layer 6, a semiconductor-based absorption layer 9, and a semiconductor-based cladding layer 12 that is provided with an elevated elongated portion 15. The semiconductor-based absorption layer and the elevated elongated portion are arranged relative to each other in such a way that an overlap between a mode field of the optical radiation that is present in the semiconductor-based core layer if the monitor photodiode is in use and the semiconductor-based absorption layer results in an optical absorption of at most 5%. The invention also relates to a PIC 100 comprising a monitor photodiode 1 according to the invention, an opto-electronic system 200 comprising such a PIC 100, and a method for fabricating the monitor photodiode 1.

It will be clear to a person skilled in the art that the scope of the present invention is not limited to the examples discussed in the foregoing but that several amendments and modifications thereof are possible without deviating from the scope of the present invention as defined by the attached claims. In particular, combinations of specific features of various aspects of the invention may be made. An aspect of the invention may be further advantageously enhanced by adding a feature that was described in relation to another aspect of the invention. While the present invention has been illustrated and described in detail in the figures and the description, such illustration and description are to be considered illustrative or exemplary only, and not restrictive.

The present invention is not limited to the disclosed embodiments. Variations to the disclosed embodiments can be understood and effected by a person skilled in the art in practicing the claimed invention, from a study of the figures, the description and the attached claims. In the claims, the word "comprising" does not exclude other steps or elements, and the indefinite article "a" or "an" does not exclude a plurality. The mere fact that certain measures are recited in mutually different dependent claims does not indicate that a combination of these measures cannot be used to advantage. Any reference numerals in the claims should not be construed as limiting the scope of the present invention.

## Claims

1. A monitor photodiode (1) for absorbing at most 5% of optical radiation to which the monitor photodiode (1) is exposed if the monitor photodiode (1) is in use, the monitor photodiode (1) comprising a substrate (2) having a first surface (3) and a second surface (4) that is arranged to face away from the first surface (3), and a layer stack (5) that is arranged on the second surface (4) of the substrate (2), the layer stack (5) comprising:
- a semiconductor-based core layer (6) having a third surface (7) that is arranged to face towards the second surface (4) of the substrate (2), and a fourth surface (8) that is arranged to face away from the third surface (7), the semiconductor-based core layer (6) being configured to guide optical radiation if the monitor photodiode (1) is in use, the semiconductor-based core layer (6) having a first surface area, A₁;
- a semiconductor-based absorption layer (9) having a fifth surface (10) that is arranged to face towards the second surface (4) of the substrate (2), and a sixth surface (11) that is arranged to face away from the fifth surface (10), the semiconductor-based absorption layer (9) having:
• a first width, W₁, seen in a direction transverse to a propagation direction, S, of the optical radiation that is present in the semiconductor-based core layer (6) if the monitor photodiode (1) is in use and parallel to the fourth surface (8) of the semiconductor-based core layer (6); and
• a first length, L₁, seen in the propagation direction, S, of the optical radiation that is present in the semiconductor-based core layer (6) if the monitor photodiode (1) is in use, the first length, L₁, being at least equal to 3µm;
the semiconductor-based absorption layer (9) having a second surface area, A₂ = W₁*L₁, that is smaller than the first surface area, A₁, of the semiconductor-based core layer (6); and
- a semiconductor-based cladding layer (12) having a seventh surface (13) that is arranged to face towards the second surface (4) of the substrate (2), and an eighth surface (14) that is arranged to face away from the seventh surface (13), the eighth surface (14) being configured to have an elevated elongated portion (15) that has:
• a second width, W₂, seen in the direction transverse to the propagation direction, S, of the optical radiation that is present in the semiconductor-based core layer (6) if the monitor photodiode (1) is in use and parallel to the sixth surface (11) of the semiconductor-based absorption layer (9); and
• a second length, L₂, seen in the propagation direction, S, of the optical radiation that is present in the semiconductor-based core layer (6) if the monitor photodiode (1) is in use, the second length, L₂, being at least equal to the first length, L₁, of the semiconductor-based absorption layer (9);
wherein the elevated elongated portion (15) of the semiconductor-based cladding layer (12) and the semiconductor-based absorption layer (9) are arranged relative to each other in such a way that an overlap between a mode field, MF, of the optical radiation that is present in the semiconductor-based core layer (6) if the monitor photodiode (1) is in use and the semiconductor-based absorption layer (9) results in an absorption of optical radiation of at most 5%.

2. The monitor photodiode (1) according to claim 1, wherein the second width, W₂, of the elevated elongated portion (15) is in a range from 200nm to 10µm and the first width, W₁, of the semiconductor-based absorption layer (9) is in a range from 0.1 W₂ to 0.5·W₂.

3. The monitor photodiode (1) according to claim 1, wherein the semiconductor-based absorption layer (9) is provided with a slot (16) that is configured and arranged to divide the semiconductor absorption layer (9) into a first portion (9a) and a second portion (9b), the first portion (9a) and the second portion (9b) being separated from each other and spaced apart as seen in the direction transverse to the propagation direction, S, of the optical radiation that is present in the semiconductor-based core layer (6) if the monitor photodiode (1) is in use and parallel to the second surface (4) of the substrate (2), the slot (16) having:
- a third width, W₃, seen in the direction transverse to the propagation direction, S, of the optical radiation that is present in the semiconductor-based core layer (6) if the monitor photodiode (1) is in use and parallel to the fourth surface (8) of the semiconductor-based core layer (6), the third width, W₃, being in a range from 0.95·W₂ to 3·W₂ depending on a desired value of the overlap between the mode field, MF, of the optical radiation that is present in the semiconductor-based core layer (6) if the monitor photodiode (1) is in use and at least one of the first portion (9a) and the second portion (9b) of the semiconductor-based absorption layer (9); and
- a third length, L₃, seen in the propagation direction, S, of the optical radiation that is present in the semiconductor-based core layer (6) if the monitor photodiode (1) is in use, the third length, L₃, being equal to the first length, L₁, of the semiconductor-based absorption layer (9).

4. The monitor photodiode (1) according to any one of the claims 1 to 3, wherein the layer stack (5) comprises a semiconductor-based spacer layer (17) that is arranged between the semiconductor-based core layer (6) and the semiconductor-based absorption layer (9), the semiconductor-based spacer layer (17) having a ninth surface (18) that is arranged to face towards the fourth surface (8) of the semiconductor-based core layer (6), and a tenth surface (19) that is arranged to face away from the ninth surface (18), the semiconductor spacer layer (17) having a third surface area, A₃, that is equal to the first surface area, A₁, of the semiconductor-based core layer (6), the semiconductor-based spacer layer (17) having a first thickness, T₁, seen in a direction transverse to the ninth surface (18), the first thickness, T₁, being in a range from 40nm to 100nm.

5. The monitor photodiode (1) according to claim 4, wherein the semiconductor-based spacer layer (17) is a p-type doped InP-based layer.

6. The monitor photodiode (1) according to any one of the claims 1 to 5, wherein the substrate (2) is an n-type doped InP-based layer.

7. The monitor photodiode (1) according to any one of the claims 1 to 6, wherein the semiconductor-based core layer (6) is a non-intentionally doped InₓGa₁₋ₓAs_{y}P_{1-y} layer.

8. The monitor photodiode (1) according to any one of the claims 1 to 7, wherein the semiconductor-based absorption layer (9) has a second thickness, T₂, seen in a direction transverse to the fifth surface (10), the second thickness, T₂, being in a range from 75nm to 150nm.

9. The monitor photodiode (1) according to any one of the claims 1 to 8, wherein the semiconductor-based absorption layer (9) is a p-type doped or non-intentionally doped InₓGa₁₋ₓAs layer.

10. The monitor photodiode (1) according to any one of the claims 1 to 9, wherein the semiconductor-based cladding layer (12) is a p-type doped InP-based layer.

11. A photonic integrated circuit, PIC, (100) comprising a monitor photodiode (1) according to any one of the claims 1 to 10, wherein the PIC (100) is a hybrid integrated PIC or a monolithic integrated PIC.

12. An opto-electronic system (200) comprising a PIC (100) according to claim 11, wherein the opto-electronic system (200) is one of a transmitter, a receiver, a transceiver, a coherent transmitter, a coherent receiver and a coherent transceiver.

13. A method (300) for fabricating a monitor photodiode (1) for absorbing at most 5% of optical radiation to which the monitor photodiode (1) is exposed if the monitor photodiode (1) is in use, the method comprising:
- providing a substrate (2) having a first surface (3) and a second surface (4) that is arranged to face away from the first surface (3);
- providing a layer stack (5) on the second surface (4) of the substrate (2), wherein providing the layer stack (5) comprises:
• epitaxially growing a semiconductor-based core layer (6) that has a third surface (7) that is arranged to face towards the second surface (4) of the substrate (2), and a fourth surface (8) that is arranged to face away from the third surface (7), the semiconductor-based core layer (6) being configured to guide optical radiation if the monitor photodiode (1) is in use, the semiconductor-based core layer (6) having a first surface area, A₁;
• epitaxially growing a semiconductor-based absorption layer (9) that has a fifth surface (10) that is arranged to face towards the second surface (4) of the substrate (2), and a sixth surface (11) that is arranged to face away from the fifth surface (10);
• performing a first lithographic process and a subsequent first etching process to configure the semiconductor-based absorption layer (9) to have:
▪ a first width, W₁, seen in a direction transverse to a propagation direction, S, of the optical radiation that is present in the semiconductor-based core layer (6) if the monitor photodiode (1) is in use and parallel to the fourth surface (8) of the semiconductor-based core layer (6); and
▪ a first length, L₁, seen in the propagation direction, S, of the optical radiation that is present in the semiconductor-based core layer (6) if the monitor photodiode (1) is in use, the first length, L₁, being at least equal to 3µm;
the semiconductor-based absorption layer (9) having a second surface area, A₂ = W₁*L₁, that is smaller than the first surface area, A₁, of the semiconductor-based core layer (6);
• epitaxially growing a semiconductor-based cladding layer (12) that has a seventh surface (13) that is arranged to face towards the second surface (4) of the substrate (2), and an eighth surface (14) that is arranged to face away from the seventh surface (13);
• performing a second lithographic process and a subsequent second etching process to configure the eighth surface (14) of the semiconductor-based cladding layer (12) to have an elevated elongated portion (15) that has:
▪ a second width, W₂, seen in the direction transverse to the propagation direction, S, of the optical radiation that is present in the semiconductor-based core layer (6) if the monitor photodiode (1) is in use and parallel to the sixth surface (11) of the semiconductor-based absorption layer (9); and
▪ a second length, L₂, seen in the propagation direction, S, of the optical radiation that is present in the semiconductor-based core layer (6) if the monitor photodiode (1) is in use, the second length, L₂, being at least equal to the first length, L₁, of the semiconductor-based absorption layer (9);
the elevated elongated portion (15) of the semiconductor-based cladding layer (12) and the semiconductor-based absorption layer (9) being arranged relative to each other in such a way that an overlap between a mode field, MF, of the optical radiation that is present in the semiconductor-based core layer (6) if the monitor photodiode (1) is in use and the semiconductor-based absorption layer (9) results in an absorption of optical radiation of at most 5%.

14. The method (300) according to claim 13, wherein the first lithographic process and the subsequent first etching process are performed to provide the semiconductor-based absorption layer (9) with a slot (16) that is configured and arranged to divide the semiconductor absorption layer (9) into a first portion (9a) and a second portion (9b), the first portion (9a) and the second portion (9b) being separated from each other and spaced apart as seen in the direction transverse to the propagation direction, S, of the optical radiation that is present in the semiconductor-based core layer (6) if the monitor photodiode (1) is in use and parallel to the second surface (4) of the substrate (2), the slot (16) having:
- a third width, W₃, seen in the direction transverse to the propagation direction, S, of the optical radiation that is present in the semiconductor-based core layer (6) if the monitor photodiode (1) is in use and parallel to the fourth surface (8) of the semiconductor-based core layer (6), the third width, W₃, being in a range from 0.95·W₂ to 3·W₂ depending on a desired value of the overlap between the mode field, MF, of the optical radiation that is present in the semiconductor-based core layer (6) if the monitor photodiode (1) is in use and at least one of the first portion (9a) and the second portion (9b) of the semiconductor-based absorption layer (9); and
- a third length, L₃, seen in the propagation direction, S, of the optical radiation that is present in the semiconductor-based core layer (6) if the monitor photodiode (1) is in use, the third length, L₃, being equal to the first length, L₁, of the semiconductor-based absorption layer (9).

15. The method (300) according to claim 13 or 14, wherein providing the layer stack (5) comprises:
• epitaxially growing a semiconductor-based spacer layer (17) after epitaxially growing the semiconductor-based core layer (6) and before growing the semiconductor-based absorption layer (9), the semiconductor-based spacer layer (17) having a ninth surface (18) that is arranged to face towards the fourth surface (8) of the semiconductor-based core layer (6), and a tenth surface (19) that is arranged to face away from the ninth surface (18), the semiconductor spacer layer (17) having a third surface area, A₃, that is equal to the first surface area, A₁, of the semiconductor-based core layer (6).
